# EUROPÄISCHE PATENTSCHRIFT

(11) **EP 1 133 593 B1**
(45) Veröffentlichungstag und Bekanntmachung des Hinweises auf die Patenterteilung: **04.09.2002**
(21) Anmeldenummer: 99958012.9
(22) Anmeldetag: 09.11.1999
(51) Int. Cl.: C30B 25/22, H01L 21/20, C30B 25/02

(54) **VERFAHREN ZUM AUFWACHSEN EINER KRISTALLINEN STRUKTUR**
GROWTH METHOD FOR A CRYSTALLINE STRUCTURE
PROCEDE DE CROISSANCE D'UNE STRUCTURE CRISTALLINE

(30) Priorität: 10.11.1998 DE 19851873
(43) Veröffentlichungstag der Anmeldung: 19.09.2001
(73) Patentinhaber: Bayerisches Zentrum für Angewandte Energieforschung e.V. ZAE Bayern, 91058 Erlangen (DE)
(72) Erfinder: BRENDEL, Rolf, D-91058 Erlangen (DE); KUCHLER, Gregor, D-91054 Erlangen (DE); ACKERMANN, Jörg, D-91054 Erlangen (DE); AUER, Richard, D-91074 Herzogenaurach (DE)
(74) Vertreter: Manitz, Finsterwald & Partner GbR
(86) Internationale Anmeldenummer: EP9908573
(87) Internationale Veröffentlichungsnummer: WO00028116

(56) Entgegenhaltungen:
- EP-A- 0 536 788
- EP-A- 0 797 258
- EP-A- 0 851 513
- US-A- 5 769 942
- PATENT ABSTRACTS OF JAPAN vol. 6, no. 119 (E-116) [997], 3. Juli 1982 (1982-07-03) & JP 57 048227 A (FUJITSU KK), 19. März 1982 (1982-03-19)

## Beschreibung

Die vorliegende Erfindung betrifft ein Verfahren zum Aufwachsen einer kristallinen Struktur auf einem eine zumindest bereichsweise kristalline Oberfläche aufweisenden Substrat unter Anwendung eines Quellenmaterials, das mindestens ein Element enthält, das zur Bildung der kristallinen Struktur auf die kristalline Oberfläche aufgebracht werden soll.

Aufgrund der verhältnismäßig hohen Anschaffungskosten für hochwertige Substrate und hochreines Quellenmaterial ist man in der Halbleiterherstellung zunehmend bemüht, sowohl Substrate preisgünstig herzustellen wie auch die entsprechenden Materialien und Quellenmaterialien wirtschaftlich auszunutzen. Im Zusammenhang mit der Herstellung von Substraten wird beispielsweise auf die europäische Patentanmeldung mit der Veröffentlichungsnummer EP-A-0 528 229 hingewiesen. Diese beschreibt ein Verfahren zur Herstellung eines Halbleiterkörpers, bei dem ein Siliziumsubstrat porös gemacht wird, eine nicht poröse, monokristalline Siliziumschicht auf dem porösen Siliziumsubstrat bei einer ersten Temperatur gebildet wird und bei dem eine Oberfläche der nicht porösen monokristallinen Siliziumschicht an ein zweites Substrat gebondet wird, das an seiner Oberfläche ein isolierendes Material aufweist Danach wird .die poröse Siliziumschicht durch ein chemisches Ätzverfahren entfernt und es wird dann eine weitere monokristalline Siliziumschicht auf die erstgenannte nicht poröse monokristalline Siliziumschicht durch ein Epitaxie-Verfahren bei einer zweiten Temperatur aufgewachsen.

Sinn dieses Verfahrens ist es, monokristallines Silizium auf einem beliebigem Substrat aufwachsen zu können. Das Verfahren ist jedoch relativ kompliziert, da die poröse Siliziumschicht weggeätzt werden muß. Ähnliche Verfahren gehen auch aus den europäischen Patentschriften mit den Veröffentlichungsnummern 0 536 788 A1 und EP 0 449 589 A1 hervor.

In der EP-A-0 767 486 wird ein Verfahren beschrieben, bei dem die poröse Schicht einen Bereich erhöhter Porosität aufweist und die Trennung des schichtartigen Gebildes vom Substrat durch mechanische Trennung im Bereich der erhöhten Porosität erfolgt. Der Bereich erhöhter Porosität wird entweder durch Ionenimplantation oder durch eine geänderte Stromdichte während der Herstellung der porösen Schicht erzeugt. Selbst wenn der Verfahrensschritt der Trennung hierdurch verbessert werden kann, gestaltet sich das Verfahren schwieriger und es besteht eine erhöhte Gefahr der ungewollten Trennung vor oder während der Erzeugung des schichtartigen Gebildes. Zwar wird hier eine mehrfache Verwendung des Ausgangssubstrats erreicht, dennoch würde man bei vielen potentiellen Anwendungen relativ verschwenderisch mit dem teuren monokristallinen Substrat umgehen.

Ein ähnlicher Vorschlag ist der EP-A-0 797 258 zu entnehmen.

Die Herstellung von kostengünstigen Silizium-Solar-Zellen verlangen hochwertiges, möglichst einkristallines Silizium für hohe Photospannungen, dünne Si-Schichten zur Materialersparnis, trotzdem ausreichende Lichtabsorption, niedrige Herstellungstemperaturen zur Energieersparnis und kostengünstige Fremdsubstrate, z.B. Glas für die mechanische Stabilität.

In der nicht vorveröffentlichten, internationalen Patentanmeldung mit der Veröffentlichungsnummer WO 99/01893 sind verschiedene Verfahren beschrieben, die es ermöglichen, aus einem Ausgangssubstrat mehrere einzelne Substrate herzustellen, die ggf. auch auf beliebige Trägermaterialien wie beispielsweise Glasscheiben aufgebracht werden können.

Beispielsweise wird in dieser PCT-Anmeldung mit der Veröffentlichungsnummer WO 99/01893 ein Verfahren zur Herstellung eines Substrats für die Halbleiterepitaxie beschrieben, das sich dadurch auszeichnet, daß man auf oder aus einem ersten Substrat eine Hohlräume aufweisende oder poröse Schicht gegebenenfalls mit einer strukturierten freien Oberfläche erzeugt oder anbringt, welche beispielsweise parallel zueinander angeordneten Rillen aufweist, daß man ein zweites Substrat auf die freie, gegebenenfalls strukturierte Oberfläche der porösen Materialschicht anbringt und das zweite Substrat anschließend vom ersten Substrat unter Anwendung der porösen Schicht als Sollbruchstelle durch die Erzeugung einer mechanischen Spannung derart abtrennt, daß eine Schicht oder Abschnitte der porösen Materialschicht auf dem zweiten Substrat haften bleibt bzw. bleiben, wodurch das zweite Substrat für Epitaxie-Verfahren verwendbar ist.

Nach der Trennung des zweiten Substrats vom ersten Substrat wird der Rest der porösen Schicht vom ersten Substrat entfernt, eine neue poröse Schicht auf dem ersten Substrat erzeugt und das Verfahren wiederholt, wobei dieses Verfahren mehrmals wiederholbar sein kann, um ausgehend von dem ersten Substrat eine Vielzahl von zweiten Substraten zu erzeugen. Die so erhaltenen zweiten Substrate haben daher an ihrer Oberfläche entweder eine durchgehende Schicht von porösen, monokristallinem Material oder - je nach Strukturierung des ersten Substrats - mehrere Inseln aus monokristallinem Halbleitermaterial. Das heißt, das zweite Substrat hat sozusagen eine zumindest bereichsweise kristalline Oberfläche mit der Besonderheit, daß auch die einzelnen kristallinen Bereiche die gleiche Kristallorientierung aufweisen.

Wenn Quellenmaterial nunmehr auf diese Oberflächen abgeschieden wird, beispielsweise mittels MBE, so wird das abgeschiedene Material auch monokristallin und die kristalline Ausrichtung der zumindest bereichsweise kristallinen Oberfläche des zweiten Substrats wird im darauf gewachsenem Material beibehalten.

Es sind aber auch andere Verfahren bekannt, bei dem man beispielsweise auf eine Glasscheibe eine zumindest bereichsweise polykristalline Siliziumoberfläche herstellt. Man kann durch Abscheidung aus der Dampfphase dann auch für Kristallwachstum auf dieser Oberfläche sorgen, wobei man dann ein Substrat erhält bestehend aus einem Träger (die ursprüngliche Glasscheibe) und auf der Oberfläche des Trägers eine polykristalline Struktur, die auch für verschiedene Zwecke bei der Herstellung von Halbleitern eingesetzt werden kann.

Für das epitaxiale oder kristalline Wachstum auf die verschiedensten Substrate sind verschiedene Methoden bekannt, wie beispielsweise die Methoden der Molekularstrahlepitaxie (MBE), der Gasphasenexpitaxie (CVD) und der Flüssigphasenepitaxie (LPE).

Dem erfindungsgemäßen Verfahren am nächsten kommt wahrscheinlich die Molekularstrahlepitaxie, die gut bekannt ist. Bei diesem Epitaxieverfahren wird ein Substrat in einer Vakuumkammer untergebracht. Die abzulagernden Materialien werden in sogenannten Effusionszellen untergebracht. Die Effusionszellen werden auf Temperaturen erhitzt, bei der die darin enthaltenen Elemente verdampfen und in Form eines Molekularstrahles auf das Substrat abgelagert werden. Die verwendeten Elemente in den Effusionszellen liegen in festem, flüssigem oder gasförmigen Zustandvor. MBE-Anlagen, die bei ultrahohem Vakuum betrieben werden, werden häufig für die Herstellung von sogenannten Verbindungshalbleitern verwendet, wie beispielsweise Alₓ Ga₁₋ₓ As. In diesem Fall befinden sich die flüssige Quelle für Ga und die feste Sublimationsquelle für As direkt nebeneinander unterhalb, jedoch relativ weit entfernt, vom Substrat. Die Effusionszellen für Aluminium und etwaige weitere Verbindungselemente oder Dotierungsstoffe sind um die Ga und As-Quellen herum angeordnet.

Nachteilig bei dem MBE-Verfahren ist einerseits die Notwendigkeit, eine aufwendige Ultrahochvakuumtechnik anzuwenden und andererseits der Verlust an Materialien aus den Effusionszellen, die sich nicht nur auf dem Substrat ablagern, sondern auch dazu neigen, sich auf die Wände und Flächen der Vakuumkammer und der darin vorhandenen Einrichtungen abzulagern. Solche Ablagerungen stellen einen Verlust an wertvollen Materialien dar, ganz abgesehen von der Notwendigkeit die Anlagen immer wieder zu reinigen.

An diese Stelle soll auf die US-A-5 769 942 hingewiesen werden. Diese Schrift beschreibt ein Verfahren und eine Vorrichtung zum Aufwachsen einer kristallinen Struktur auf einem Substrat. Die Vorrichtung besteht aus einer Vakuumkammer, einer in der Kammer angeordneten Halterung für ein Substrat, einer Halterung für ein im festen Zustand vorliegendes Quellenmaterial und einer Heizvorrichtung zur Erhitzung des Quellenmaterials. Die Beispiele zeigen einen Abstand zwischen dem Substrat und dem Quellenmaterial vom 10 µm bis 1000µm. Es wird eine Lichtquelle als Heizvorrichtung vorgeschlagen.

Bei der Gasphasenepitaxie, die vor allem bei der Herstellung von Silizium-Halbleitern eine Rolle spielt, werden die abzulagernden Siliziumatome in der Gasphase in die Behandlungskammer eingeführt, beispielsweise in Form von Silan. Silan ist jedoch ein relativ teures Material und ist auch selbstentzündlich und führt somit zu hohen Sekundärkosten in der Sicherheitstechnik.

Die Flüssigphasenepitaxie wird - wie der Name schon sagt - in flüssigem Zustand durchgeführt. Zu diesem Zweck werden die zu beschichtenden Substrate in einem sogenannten Schiff untergebracht und dann im Bodenbereich von flüssigen Bestandteilen enthaltenden Behälter hineingeschoben, wodurch sich das flüssige Material mit dem Substrat verbindet. Das Verfahren ist zwar weit verbreitet, führt aber zwangsläufig zu dem Nachteil, daß die Oberfläche des Substrats angeschmolzen wird. Elemente aus den einzelnen Quellen kommen auf diese Weise und andere Weise in die anderen Quellen, so daß diese kontaminiert werden und daher wieder aufbereitet werden müssen, bevor sie zur erneuten, mehrfachen Anwendung gelangen. Das Zurückschmelzen der Oberfläche des Substrats ist für viele Zwecke nicht akzeptabel. Das Verfahren als Ganzes läßt die Herstellung von vielen in der Halbleitertechnik gewünschten Strukturen nicht zu.

Aufgabe der vorliegenden Verfahren ist es, ein Verfahren bzw. eine Vorrichtung der eingangs genannten Art zu schaffen, bei dem bzw. der man ein Epitaxieverfahren preisgünstig unter zumindest im wesentlichen vollständigen Ausnutzung eines Quellenmaterials, vorzugsweise mit geringer Verunreinigung, durchführen kann. Erfindungsgemäß wird bei einem Verfahren der eingangs genannten Art so vorgegangen, daß das Quellenmaterial während des Aufwachsverfahrens im festen Zustand vorliegt und eine Flächenausdehnung aufweist, die zumindest im wesentlichen der des Substrats entspricht und zu dieser parallel gegenüberliegend angeordnet ist, daß das Quellenmaterial durch seine Porosität und/oder Oberflächenstrukturierung eine größere wirksame Oberfläche als die des Substrats aufweist und daß zumindest das Quellenmaterial auf eine Temperatur unterhalb dessen Schmelzpunkt erhitzt wird.

Das neue Verfahren unterscheidet sich vom Verfahren der US-A-5 769 942 dadurch, daß das Quellenmaterial durch seine Porosität und/oder Oberflächenstrukturierung eine größere, wirksame Oberfläche als die des Substrats aufweist. Gegenüber den anderen bisher bekannten Verfahren unterscheidet sich das vorliegende Verfahren auch durch die Verwendung einer Materialquelle im festen Aggregatzustand und durch die zumindest im wesentlichen gleiche Flächenausdehnung der zumindest bereichsweise kristallinen Oberfläche des Substrats und der diesem (eng) gegenüberliegenden Oberfläche des Quellenmaterials. Das heißt, die Form und Größe der kristallinen Oberfläche des Substrats entspricht zumindest im wesentlichen der Form und Größe der gegenüberliegenden Oberfläche des Quellenmaterials.

Auf diese Weise gelingt es, Material von der Quelle auf das Substrat aufzubringen, so daß das aufgebrachte Material die Kristallorientierung beibehält, die an der Oberfläche des Substrats herrscht. Darüber hinaus wird das Quellenmaterial zumindest im wesentlichen vollständig verwertet. Es kommt nur zu einer sehr geringen Verschmutzung der Apparatur mit dem Quellenmaterial.

An dieser Stelle ist es angebracht, den physikalischen Hintergrund für dieses neuartige Verfahren zu erläutern.

Bei gleicher Temperatur von Substrat und Quellenmaterial, das üblicherweise in Form eines Wafers vorliegen wird, ist die Zahl der Atome, die pro Zeit und Flächeneinheit von Substrat bzw. Quellenmaterial abdampfen, gleich. Die Erfindung bewirkt nun einen erhöhten Materialtransport in Richtung vom Quellenmaterial zum Substrat.

Gibt man dem Quellenmaterial eine größere, wirksamere Oberfläche als die des Substrats, beispielsweise dadurch, daß man das Quellenmaterial porös macht und/oder ihm eine Oberflächenstrukturierung gibt, bewirkt diese im Vergleich zum Substrat größere Oberfläche des Quellenmaterials bzw. Quellwafers bewirkt einen effektiven Materialtransport vom Quellenmaterial bzw. Quellwafer zum Substrat. Dieser Transport findet im oder zumindest nah am thermischen Gleichgewicht statt.

Die Schaffung eines unterstützenden Temperaturunterschieds zwischen dem Quellenmaterial und dem Substrat kann die Abdampfrate vom Quellenmaterial gegenüber dem Substrat erhöhen, was auch zu einem gesteigerten, effektiven Materialtransport vom Wafer zum Substrat führt.

Der Materialtransport erfolgt bei dem bisher Gesagten auf rein physikalischem Weg durch das Abdampfen von atomarem bzw. molekularem Quellenmaterial ohne chemische Reaktion. Zu diesem Zweck kann die Gasatmosphäre für die Reaktion aus einem Inertgas, insbesondere aus Argon, bestehen, d.h. aus einem Inertgas, das mit dem Material des Substrats und der Quelle nicht reagiert.

Die Gasatmosphäre kann aber aus einem Gas oder einer Gasmischung bestehen, das bzw. die eine chemische Oberflächenreaktion mit dem Material der Quelle bzw. des Substrats eingeht. Im Falle der Verwendung von Silizium als Quellenmaterial und H₂ für die Gasatmosphäre reagiert beispielsweise der Wasserstoff mit dem Silizium, um Silan (SiH₄) zu bilden, wobei das so erzeugte Silan dann entsprechend dem Vorgehen bei Gasphasenepitaxie zu der Ablagerung von Silizium auf der Oberfläche des Substrats führt.

Man kann sagen, daß die Gasatmosphäre in beiden Fällen als Trägermedium wirkt. Im Falle einer chemischen Oberflächenreaktion stellt sie zudem die benötigten Reaktionspartner für das Quellenmaterial zur Verfügung. Im Falle von Silizium z.B. Wasserstoff zur Bildung von Silan.

Da die Abscheidung auf das Substrat nahe am thermischen Gleichgewicht erfolgt, verspricht das erfindungsgemäße Verfahren gegenüber den genannten Methoden eine verbesserte Kristallqualität. Der geringe Abstand zwischen Quellenmaterial und Substrat bewirkt, daß ein deutlich größerer Raumwinkel der Substratoberfläche durch das Quellenmaterial bzw. den Quellwafer abgedeckt wird. Die Substratoberfläche ist aufgrund der Erfindung nur einem vergleichsweise geringem Raumwinkel der Rezipientenwand ausgesetzt. Aus diesem Grund werden unerwünschte Verschmutzungen durch Abdampfen oder Ausgasen von Verunreinigungen von Wandflächen des Rezipienten weitgehend vermieden.

Besonders günstig ist bei dem erfindungsgemäßen Verfahren, daß es in einem Rezipienten über einen breiten Druckbereich ausgeführt werden kann, theoretisch in einem Bereich, der von mindestens 10⁻¹² hPa zu 10⁺⁶ hPa reicht. In der Praxis wird das Verfahren aber vorzugsweise bei einem Druck durchgeführt, der in einem engen Bereich von 10⁻⁶ hPa bis 10⁺⁴ hPa liegt.

Bei einem Unterdruck von 10⁻⁶ hPa oder kleiner sind die Anforderungen an das Vakuumsystem wesentlich geringer als bei dem Ultrahochvakuumsystem, das in einer normalen MBE-Lage angewandt wird.

Die Anschaffungs- und Betriebskosten für das Vakuumsystem sind daher günstiger und die Pumpzeiten kürzer, was ebenfalls zur Wirtschaftlichkeit des erfindungsgemäßen Verfahrens beiträgt.

Bei einem Überdrucksystem erscheint es kaum sinnvoll, Drücke über 10⁺⁴ hPa zu verwenden, da sonst die mechanischen Forderungen an den Rezipienten und das diesem zugeordneten Überdrucksystem größer werden und Sicherheitsüberlegungen zu einer Verteuerung der Anlage rühren können. Am kostengünstigsten erscheint es, wenn das Verfahren bei annähernd atmosphärischem Druck bzw. bei leichtem Überdruck durchgeführt wird, da hier kein Vakuumsystem erforderlich ist. Der Rezipient kann beispielsweise mit Inertgas und/oder gasformigem Wasserstoff gespült werden. Die Sicherheitsanforderungen für die Handhabung von höheren Drücken entfallen. Außerdem ist es dann möglich, den Rezipienten schnell zu öffnen und wieder zu verschließen, so daß der Durchsatz an Substraten am größten sein darf.

Es besteht auch die Möglichkeit, die zumindest bereichsweise kristalline Oberfläche des Substrats und/oder die der kristallinen Oberfläche gegenüberliegenden. Oberfläche des Quellenmaterials mit Licht oder einem Plasma anzuregen. Hierdurch kann im Falle des Substrats die Aufteilung der Siliziumverbindungen in abgelagertes Silizium und Gasbestandteile positiv beeinflußt werden. Im Falle des heißeren Quellenmaterials kann die Bildung der Siliziumverbindungen im Vordergrund stehen.

Die Möglichkeit besteht auch, in einem Rezipienten mehrere Substrate und mehrere Materialquellen mit dem gleichen oder unterschiedlichen Materialien zu benutzen. Somit kann man nach einmaliger Öffnung des Rezipienten mehrere Substrate einsetzen und behandeln, was wirtschaftlicher sein dürfte als wenn man für jedes Substrat einzeln den Rezipienten öffnen und wieder verschließen muß.

Darüber hinaus besteht erfindungsgemäß die Möglichkeit, mehrere verschiedene Substrate mit jeweiligen, ggf. auch verschiedenartigen Materialquellen zu behandeln, da die Tatsache, daß die zumindest bereichsweise kristalline Oberfläche des Substrats und der gegenüberliegenden Oberflä

che des Quellenmaterials nur einen kleinen Abstand voneinander aufweisen, sicherstellt, daß die Gefahr der Verunreinigung des Substrats mit Material von einer anderen Quelle gering bleibt.

Es besteht weiterhin die Möglichkeit, die relative Zuordnung der einander gegenüberliegenden Substrate zu den Materialquellen zu verändern.

Auf diese Weise könnten beispielsweise Schichten mit unterschiedlichen Zusammensetzungen sukzessiv auf das eine Substrat abgelagert werden, indem das erste Substrat erst gegenüber einer ersten Materialquelle behandelt wird, um eine erste Schicht daran aufzuwachsen und dann, beispielsweise durch die Bewegung eines drehbaren Tisches, in Gegenüberstellung mit einem zweiten Quellenmaterial gebracht wird, wodurch eine zweite Schicht auf die freie Oberfläche der ersten Schicht aufgebracht wird. Dieses Verfahren ist selbstverständlich nicht auf die Anbringung von zwei Schichten beschränkt.

Es soll an dieser Stelle zum Ausdruck gebracht werden, daß das erfindungsgemäße Verfahren nicht nur mit Substraten mit kristallinen Oberflächen aus Si angewandt werden kann. Das Verfahren ist vielmehr allgemein gültig und kann mit jedem Material, sei es Element oder Verbindung, benutzt werden, wo kristallines Wachstum erwünscht ist. Das Verfahren kann mit Substraten mit polykristallinen Oberflächen oder Substraten mit monokristallinen Oberflächen verwendet werden.

Beispielsweise ist es durchaus zu erwarten, daß alle Verbindungshalbleiter sich auf diese Weise herstellen lassen, z.B. Verbindungshalbleiter auf Alₓ Ga₁₋ₓ As Basis.

Mittels des erfindungsgemäßen Verfahrens können auch dotierte Schichten erzeugt werden, wenn man die entsprechenden Dotierungsstoffe der Gasatmosphäre zwischen dem Substrat und dem Quellenmaterial zuführt. Beispielsweise bei Verwendung von Si als Quellenmaterial kann man Diboran für die p-Dotierung und Phosphin für die n-Dotierung verwenden.

Eine erfindungsgemäße Vorrichtung zum Aufwachsen einer kristallinen Struktur auf einem, eine zumindest bereichsweise kristalline Oberfläche aufweisenden Substrat unter Anwendung eines Quellenmaterials, das mindestens ein Element enthält, das auf die kristalline Oberfläche aufzubringen ist, besteht aus einem Rezipienten, aus einem im Rezipienten angeordneten Halter für das Substrat, aus einem im Rezipienten angeordneten Halter für ein in festem Zustand vorliegenden Quellenmaterial, der zur Halterung des Quellenmaterials in einer Orientierung mit seiner Oberfläche parallel zur Oberfläche des Substrats und diesem Gegenüberliegend in einem Abstand kleiner als etwa 1/10 der Flächenausdehnung des Substrats, vorzugsweise kleiner als 10 mm und insbesondere kleiner als 1 mm ausgelegt ist, und aus einer Heizeinrichtung zur Erhitzung des Quellenmaterials auf eine Temperatur unterhalb des Schmelzpunktes.

Besonders bevorzugte Varianten des erfindungsgemäßen Verfahrens bzw. der Vorrichtung sind den Unteransprüchen zu entnehmen.

Die Erfindung wird nachfolgend näher erläutert anhand von Ausführungsbeispielen unter Bezugnahme auf die Zeichnung, in der zeigen:
- Fig. 1: einen schematischen Querschnitt durch eine Vorrichtung zur Durchführung des erfindungsgemäßen Verfahrens,
- Fig. 2A und 2B: Skizzen von einer Vorrichtung ähnlich der der Fig. 1 zur Klarstellung, wie beim erfindungsgemäßen Verfahren die zu erwartenden Verunreinigungen durch Herabsetzung des Abstandes zwischen Substrat und Quellenmaterial kleingehalten werden kann,
- Fig. 3A-3F: Skizzen um eine besonders bevorzugte Ausführungsform des erfindungsgemäßen Verfahrens darzustellen, wobei die Fig. 3A eine Querschnittszeichnung ähnlich der Fig. 1, jedoch in einem größeren Maßstab und ohne überflüssige Details zeigt und die weiteren Figuren 3B bis 3F weitere Stufen des Verfahrens zur Herstellung einer Solarzelle angeben,
- Fig. 4A und 4B: die direkte Abscheidung von lateral definierten Strukturen ohne weitere Strukturierungsschritte, wie z.B. Photolithographie einer schon abgeschiedenen Schicht vornehmen zu müssen, und zum Vergleich
- Fig. 4C und 4D: die Erzeugung einer durchgehenden kristallinen Schicht auf das Substrat

In allen Figuren werden gleiche oder einander entsprechende Teile mit den gleichen Bezugszeichen versehen.

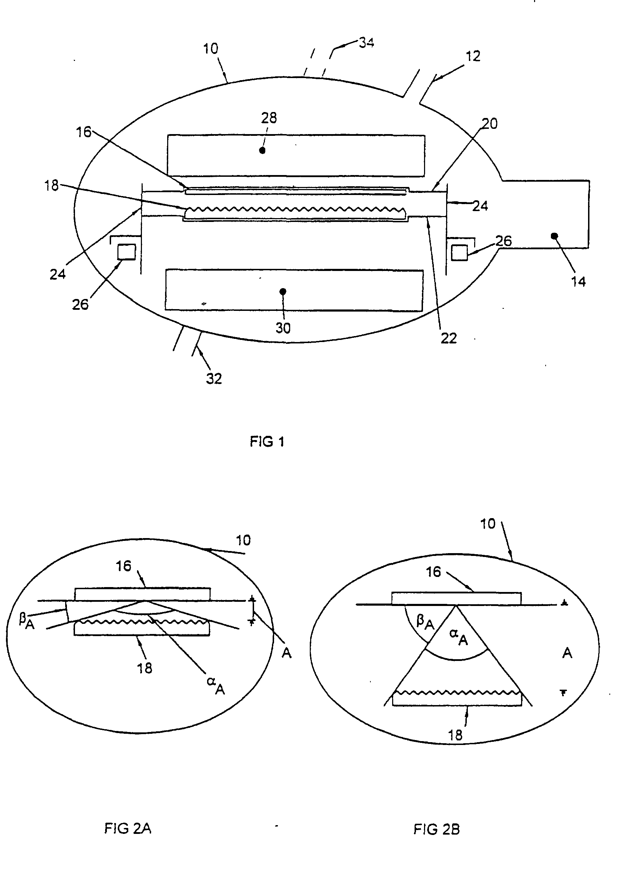

Die schematische Zeichnung der Fig. 1 zeigt mit 10 einen Rezipienten, der hier als Vakuumkammer ausgebildet und mit einem Gaseinlaß 12 und einer Vakuumpumpe 14 sowie einer nicht gezeigten, aber verschließbaren Öffnung versehen ist. Innerhalb des Rezipienten befinden sich ein Substrat 16 und ein Quellenmaterial 18 in Form eines Wafers mit einer strukturierten Oberfläche. Das Substrat 16 wird von einem Substrathalter 20 und das Quellenmaterial in Form eines Quellwafers 18 wird von einem Halter 22 gehalten, wobei die beiden Halter 20 und 22 in diesem Beispiel an einem gemeinsamen Rahmen 24 angebracht sind, der beispielsweise an entsprechenden Schienen 26 gleitbar gelagert ist, damit der Aufbau bestehend aus dem Rahmen 20 die beiden Halter 20 und 22 mit dem Substrat 16 und dem Quellenmaterial 18 durch die oben erwähnte, jedoch nicht gezeigte Öffnung in den Rezipienten hineingeschoben und aus diesem herausgezogen werden können.

Im übrigen ist mindestens einer der Halter 20, 22 verstellbar angeordnet, damit der Abstand zwischen den einander gegenüberliegenden Oberflächen des Substrats 16 und des Quellwafers 18 verändert werden kann.

Oberhalb des Substrathalters 20 befindet sich eine Heizeinrichtung 28 für das Substrat, während eine weitere Heizeinrichtung 30 für das Quellenmaterial unterhalb des entsprechenden Halters 22 angeordnet ist.

Fig. 1 ist zu entnehmen, daß das Quellenmaterial in Form eines Quellwafers mit einer strukturierten Oberfläche versehen ist, hier in Wellenform angedeutet. Allein aus dieser Zeichnung ist ersichtlich, daß das Substrat 16 und der Quellwafer 18 zwar die gleiche Flächenausdehnung haben, d.h. die gleiche Größe und Form oder Umriß. Der Quellwafer 18 hat jedoch eine größere, wirksamere Oberfläche als die gegenüberliegende Oberfläche des Substrats 16.

Dies bedeutet, daß auch wenn das Substrat 16 und der Quellwafer 18 auf die gleiche Temperatur erhitzt werden, mehr Material von der wirksamen Oberfläche des Quellwafers abgedampft wird als von der Oberfläche des Substrats, so daß insgesamt ein Materialtransport vom Quellwafer auf das Substrat zu stattfindet. Die Temperaturen des Substrats und des Quellwafers sind durch Einstellung der jeweiligen Heizeinrichtungen 28 bzw. 30 so eingestellt, daß beide noch in festem Zustand sind.

Der Materialtransport vom Quellwafer 18 zum Substrat 16 kann weiter erhöht werden, wenn die Temperatur des Substrats etwas niedriger gewählt wird als die Temperatur des Quellwafers.

Zum Beispiel kann zur Vergrößerung seiner effektiven Oberfläche der Quellwafer bzw. wenigstens der dem Substrat gegenüberliegende Oberflächenbereich des Quellwafers porös gemacht werden. Dabei kann die Porosität P, d.h. der Volumenanteil der Poren im Vergleich zum Gesamtvolumen des porösen Bereiches, in einem weiten Bereich 0 % < P < 100 % gewählt werden. Die Strukturierung der Oberfläche des Quellwafers, die bei einer porösen Oberfläche nicht unbedingt erforderlich ist, kann durch chemische und/oder mechanische Einwirkung erzielt werden. Der Quellwafer 18 mit vergrößerter Oberfläche wird entweder in unmittelbaren Kontakt mit oder nur in einem geringen Abstand von dem zu beschichtenden Substrat 16 gebracht, so daß der gegenseitige Abstand A beispielsweise im Bereich 0 µm ≤ A ≤ 10 mm liegt. Auf jeden Fall wird erfindungsgemäß angestrebt, den Abstand zwischen den gegenüberliegenden Oberflächen des Substrats und des Quellwafers kleiner als 1/10 der Flächenausdehnung des Substrats zu wählen, wobei die Flächenausdehnung in diesem Zusammenhang beispielsweise als die größte Querabmessung des Substrats verstanden werden kann.

Bei einem porösen Quellwafer oder einem Quellwafer mit strukturierter Oberfläche bedeutet der Abstand A = 0 µm, daß die Spitzen der Strukturierung bzw. die erhöhten Stellen der porösen Oberfläche mit dem Substrat in Berührung sind.

Als Heizeinrichtungen können z.B. Infrarotstrahlungsheizer oder Graphit-Widerstandsheizer verwendet werden. Diese können beide so ausgelegt werden, daß beispielsweise Temperaturen im Bereich zwischen 400°C und 1300°C gewählt werden können. Die konkret anzuwendenden Temperaturen hängen vom Material des Substrats 16 und vom Material des Quellwafers 18 ab und sollen jeweils so gewählt werden, daß ein Schmelzen des Substrats bzw. des Quellwafers nicht eintritt und diese jeweils im festen Zustand verbleiben. Es kann auch ein Temperaturunterschied von bis zu 500°C zwischen dem heißeren Quellwafer 18 und dem kühleren Substrat 16 verwendet werden. Je höher der Temperaturunterschied, desto größer der Materialtransport vom Quellwafer 18 zum Substrat 16. Dennoch sind derzeit kleinere Temperaturunterschiede von nur 50 bis 150°C bevorzugt, da die höhere Temperatur des Substrats zu einer besseren Kristallqualität führt, da die Beweglichkeit der einzelnen Atome erhöht ist und etwaige Kristallfehler durch die selbstorganisierende Fähigkeit der Kristallstruktur leichter ausgeheilt werden können.

Bei dem dargestellten Beispiel wird im Rezipient eine Gasatmosphäre mit einem Gesamtdruck im Bereich zwischen 10⁻⁶ hPa und Atmosphärendruck geschaffen. Der jeweils günstigste Druck kann experimentell für verschiedene Substrate und Quellwafer ermittelt werden. Eine Ausführungsform ist aber auch denkbar, bei der der Rezipient nicht als Vakuumkammer zu verstehen ist, sondern als Druckbehälter, wobei dann Gasatmosphären mit Überdrucken bis zu 10⁺⁴ hPa ohne weiteres in Frage kämen.

Wenn sowohl das Substrat wie auch das Quellenmaterial aus Silizium bestehen, wird die Gasatmosphäre durch ein Inertgas, beispielsweise Argon, gebildet oder durch ein reaktives Gas, wie beispielsweise H₂, Br₂, Cl₂ oder HCl. Auch Mischungen aus einem Inertgas und einem reaktiven Gas oder aus verschiedenen reaktiven Gasen untereinander kämen in Frage. Man muß sich nur jeweils Gedanken über die zu erwartenden chemischen Reaktionen machen.

Wenn beispielsweise die Gasatmosphäre aus H₂ besteht, wird der Wasserstoff bevorzugt mit der heißeren Oberfläche des Quellwafers reagieren und Silan (SiH₄) bilden, das dann in Berührung mit der unmittelbar gegenüberliegenden Oberfläche des Substrats 16 gelangt und dort mit Freigabe des Wasserstoffs als Silizium auskristallisiert, wobei die kristalline Struktur des Substrats durch das abgeschiedene Siliziummaterial fortgesetzt wird.

Bei einem Siliziumsubstrat wird eine Substrattemperatur T im Bereich zwischen 700 und 850°C und eine Temperatur des Quellenmaterials im Bereich zwischen 800 und 1000°C gewählt, wobei die Temperatur des Quellenmaterials stets etwa 100 bis 150°C höher sein soll als die Temperatur des Substrats.

Bei der Ausbildung des Behälters als Druckkammer können die Pumpen 14 entfallen. Statt dessen wird eine Gasquelle mit Überdruck an den Gaseinlaß 12 angeschlossen. Eine Spülung des Rezipienten ist über die Auslaßöffnung 32 möglich, wobei entsprechende Ventile für die Öffnung und Schließung des Gaseinlasses 12 und der Spülöffnung 32 vorzusehen sind.

Das Bezugszeichen 34 deutet auf einen weiteren Gaseinlaß hin, diesmal zur Einführung von Dotierungsstoffen, wie beispielsweise Diboran oder Phosphin für die p- bzw. n-Dotierung des Siliziummaterials. Natürlich können weitere Gaseinlässe vorgesehen werden, beispielsweise dann, wenn man p- und n-Dotierungsstoife aus einem bestimmten Grund nicht durch den gleichen Einlaß einfließen lassen möchte.

Die Figuren 2A und 2B zeigen den Einfluß des Abstandes zwischen Substrat 16 und Quellwafer 18 auf den Raumwinkel α des Substrats, der vom Quellwafer 18 abgedeckt wird. Die große Raumwinkelabdeckung α_{A} in Figur 2A, die bei kleinem Abstand zwischen dem Substrat 16 und dem Quellwafer 18 erreicht wird, bedeutet wenig Verunreinigung durch Wandeffekte, deren Raumwinkel β_{A} klein ist. In Figur 2B ist der Raumwinkel β_{B} der Rezipientenwand deutlich größer, weil der Abstand zwischen dem Substrat 16 und dem Quellwafer 18 größer und der Raumwinkel α_{A} kleiner ist.

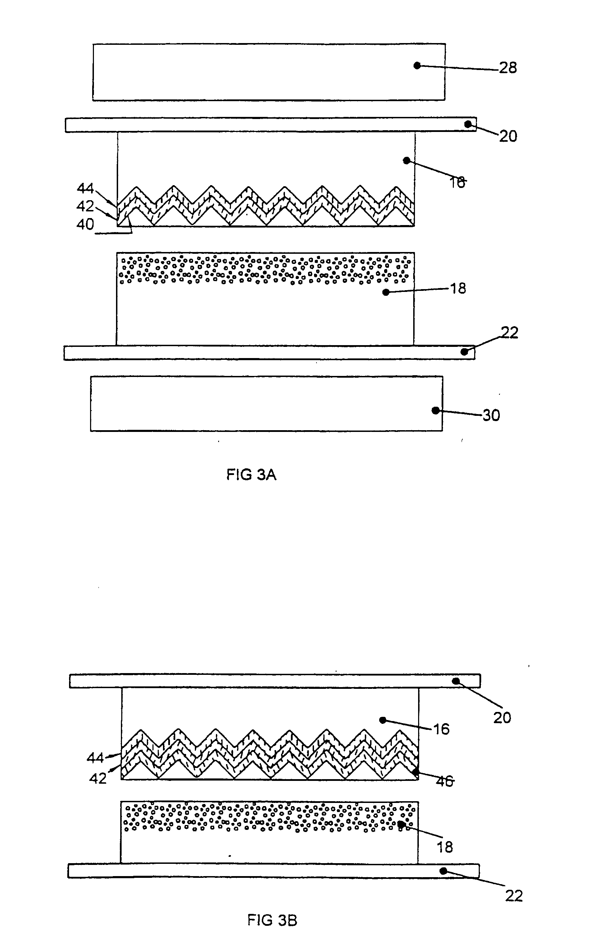

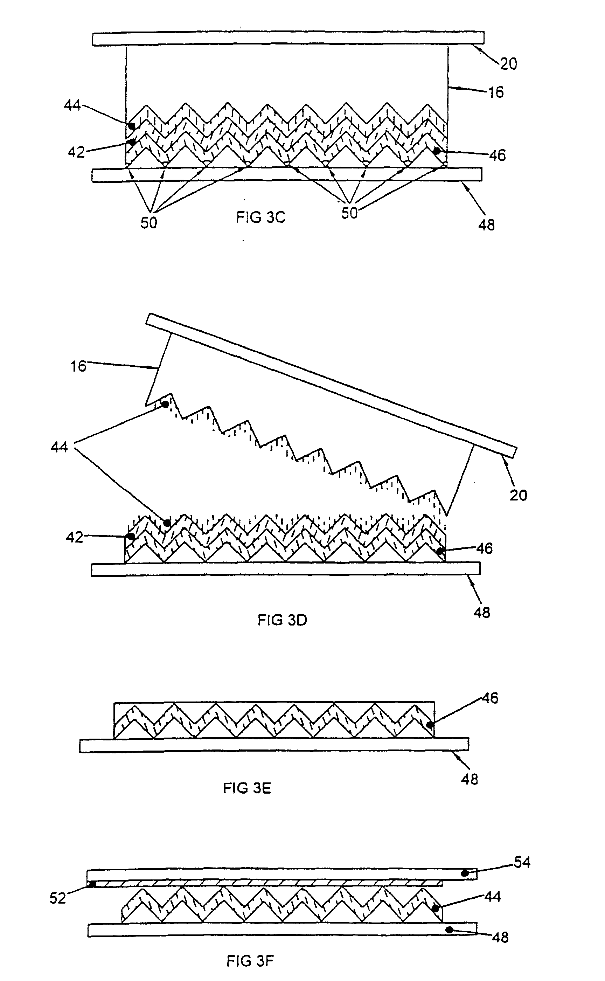

Die Ausführung gemäß Figur 3 zeigt eine bevorzugte Anwendung der Erfindung in einem Zwischenschritt bei der Herstellung von Solarzellen. Auch hier deutet das Bezugszeichen 16 auf das Substrat, wobei ersichtlich ist, daß hier das Substrat eine strukturierte Oberfläche 40 aufweist.

Die Strukturierung dieser Oberfläche entspricht der Oberflächenstrukturierung gemäß Figur 1A, bzw. Figur 9 der PCT-Anmeldung mit der Veröffentlichungsnummer WO 99/01893. Die Strukturierung der Oberfläche 40 ist in Draufsicht als eine Matrix von pyramidenförmigen Vertiefungen zu betrachten, deren Grundflächen unmittelbar nebeneinander plaziert sind, so daß die in Figur 3A untere Begrenzung der Oberfläche einem quadratischen Gitter sehr ähnlich ist. Der Zeichnung ist zu entnehmen, daß das dem Quellwafer 18 zugewandte Stirnende des Substrats 16 zwei parallel zueinander verlaufende Schichten 42 und 44 aufweist, wobei die Schicht 42 eine kleinere Porosität, beispielsweise < 20 % und die Schicht 44 eine größere Porosität, beispielsweise > 50 % aufweist. Das Substrat 16 als Ganzes besteht aus monokristallinem Siliziummaterial. Nach der Herstellung der zwei strukturierten porösen Schichten, welche in der PCT-Anmeldung mit der Veröffentlichungsnummer WO 99/01893 beschrieben ist, wobei die Herstellung von porösen Schichten, auch Schichten unterschiedlicher Porosität, auch im vorveröffentlichten Stand der Technik, beispielsweise in der europäischen Anmeldung EP-A-0 767 486 beschrieben ist, wird das Substrat mit diesen zwei porösen Schichten mit dem Quellwafer 18 in den Rezipienten 10 eingesetzt.

Der Quellwafer 18 besteht in diesem Falle aus polykristallinem oder monokristallinem Si und ist auch porös gemacht worden, und zwar mit einer Porosität deutlich größer als die Porosität der Schicht 42, damit die wirksame Oberfläche des Quellwafers 18 größer ist als die der strukturierten und porösen Oberfläche des Substrats 16. Die Temperatur des Substrats 16 wird wie bisher im Bereich zwischen 700 und 850°C gewählt und die Temperatur des Quellwafers wird durch entsprechende Einstellung der Heizeinrichtung 30 auch wie bisher auf 800 bis 100°C gestellt, wobei die Temperatur des Quellwafers höher gewählt wird als die des Substrats 16. Gleichzeitig wird Phosphin-Gas der Wasserstoffatmosphäre des Rezipienten zugeführt, so daß sich eine n-Typ monokristalline Siliziumschicht 46 auf der strukturierten Oberfläche 40 ausbildet, wie in Figur 3B gezeigt.

Nach Herstellung dieser Schicht wird das Substrat 16 aus dem Rezipienten entfernt, die Siliziumschicht 46 in Berührung mit einer Aluminiumplatte 48 gebracht (Figur 3C) und eine Wärmebehandlung durchgeführt, wodurch Alumimiumatome in die Spitzen des schichtartigen Gebildes hinein diffundieren, was durch das Bezugszeichen 50 gezeigt ist und erzeugen dort anstelle n-Typ Si, p-Typ Si, d.h. es wird auf diese Weise der pn-Übergang geschaffen, der für eine Photozelle erforderlich ist.

Es kann jetzt die monokristalline Schicht 46 vom Substrat 16 getrennt werden, beispielsweise durch ein mechanisches Trennverfahren wie in Fig. 3D schematisch angedeutet, wodurch die Schicht 44 mit der größeren Porosität als eine Sollbruchstelle funktioniert. Man merkt, daß Reste der Schicht 44 auf der Oberfläche des Substrats 16 und der Schicht 42 verbleiben können, die zu entfernen sind. Danach muß das poröse Material, d.h. die Schicht 42, vom nichtporösen Material 46 getrennt werden, was zu dem Zustand der Fig. 3E führt, und es kann dann gemäß Fig. 3F die . Solarzelle mit einer fingerartigen Elektrode 52 und einer Abdeckplatte 54 versehen werden, wodurch sich die Struktur gemäß Figur 8 der PCT-Anmeldung mit der Veröffentlichungsnummer WO 99/01893 ergibt.

Die Entfernung von porösem Material von nicht porösem kann auf die verschiedenste Art und Weise erfolgen, beispielsweise durch chemisches Ätzen (KOH) oder mechanisches Entfernen in an sich bekannter Weise (Ultraschallverfahren).

Unter Umständen kann es günstiger sein, die monokristalline Schicht 46 vom Substrat 16 zu trennen, bevor die Schicht 46 in Berührung mit der Aluminiumplatte 46 gebracht wird. Die Trennung muß auch nicht mechanisch erfolgen, sondern kann auch auf elektrolytische Weise erfolgen, wie ebenfalls in der PCT-Anmeldung mit der Veröffentlichungsnummer WO 99/01893 beschrieben.

Es sind vielerlei Variationen denkbar. Anstelle einer Schicht 46 aus n-Typ Si, könnte diese Schicht als eine erste Lage n-typ Si und eine zweite Lage p-Typ Si realisiert werden. Darüber hinaus kann die Strukturierung der Schicht anders gewählt werden, beispielsweise entsprechend den Figuren 18 und 19 der PCT-Anmeldung mit der Veröffentlichungsnummer WO 99/01893.

Nach der Entfernung der Schicht 46 vom Substrat 16 kann dieses gereinigt, wieder porös gemacht und weiterverwendet werden, um eine weitere monokristalline Schicht 46 zu erzeugen. Es soll darauf hingewiesen werden, daß eine erneute Strukturierung der "neuen" Oberfläche 40 des Substrats 16 nicht erforderlich ist. Wenn eine strukturierte Oberfläche porös gemacht wird, beispielsweise zur Herstellung der beiden ersten Schichten 42 und 44, behält die Grenzfläche zum nicht porösen Substrat die gleiche Strukturierung wie die ursprüngliche Oberfläche. Das soeben beschriebene Verfahren kann auch mehrfach wiederholt werden, wobei die allmähliche Verkürzung der Höhe des Substrats 16 durch Verstellung des Halters 20 bzw. des Halters 22 ausgeglichen werden kann, so daß der Abstand zwischen der strukturierten Oberfläche 40 und der Oberfläche des Quellwafers konstant bleibt und auch die Tatsache berücksichtigt, daß auch der Quellwafer in der Höhe kleiner wird.

Es werden jetzt einige Erweiterungen des Grundverfahrens beschrieben, welche sowohl mit der Ausführung gemäß Figur 1 als auch mit Ausführung gemäß Figur 3 verwendet werden können.

Der Materialtransport kann durch rein thermische Anregung geschehen (wie oben beschrieben) oder durch zusätzliche Maßnahmen wie die lokale Anregung der Wafer und/oder Substratoberfläche durch den Einsatz von hochintensivem Licht oder Laserlicht oder durch Plasmaanregung. Statt des oder zusätzlich zum Wasserstoffgas in der Atmosphäre des Rezipienten können Halogengase verwendet werden, und andere Gase kommen eventuell in Frage.

Ist die künstlich vergrößerte Oberfläche des Wafers durch den Abscheideprozeß verbraucht bzw. verkleinert, kann sie durch eine Wiederholung der ursprünglichen Behandlung wieder vergrößert und für weitere Abscheidungen genutzt werden. Dadurch läßt sich das Material des Wafers zu nahezu 100 % für die Abscheidung nutzen. Durch den geringen Abstand von Quellwafer und Substrat gelangen nahezu 100 % des vom Wafer desorbierten Materials auf das Substrat. Diese extrem hohe Materialausbeute macht das Verfahren besonders für Anwendungen auf einem Massenmarkt, z.B. epitaktische Schichten für Dünnschichtsolarzellen, interessant, wo der Materialpreis der dominierende Beitrag zu den Gesamtkosten ist.

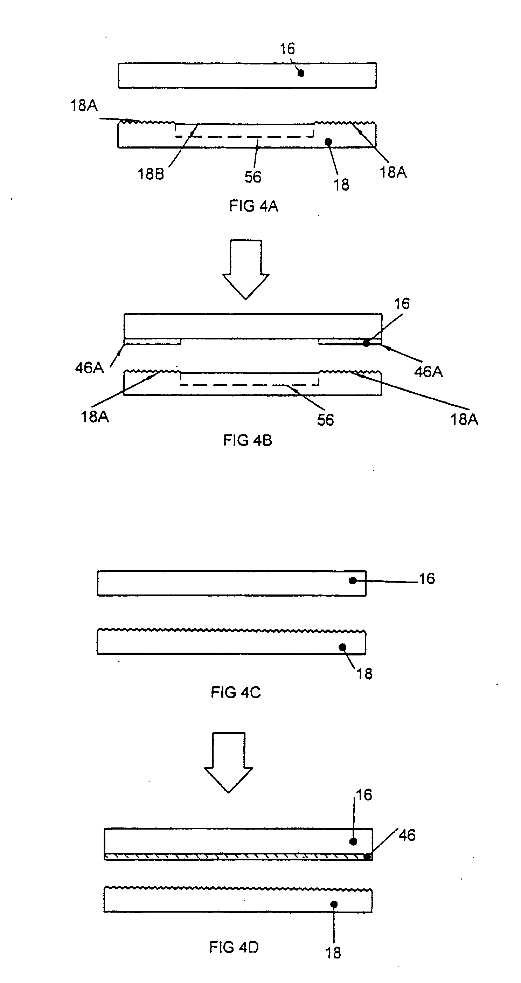

Die Möglichkeit, die künstlich vergrößerte Oberfläche des Quellwafers zu strukturieren, bietet auch durch die Wahl einer geeigneten Strukturierung das direkte Abscheiden von lateral strukturierten Schichten, also von dreidimensionalen Gebilden auf dem Substrat 18. Dies wird jetzt im Zusammenhang mit der Fig. 4A näher erläutert werden. Der Quellwafer 18 wird zuerst homogen behandelt, so daß seine Oberfläche künstlich vergrößert ist, wie in Fig. 1 bzw. in Fig. 4C dargestellt. Das heißt, es liegt ein Quellwafer mit homogen vergrößerter Oberfläche vor. Behandelt man weiter, z.B. durch Photolithographie eingeschränkte Gebiete 18B so, daß die Oberfläche wieder in ihren ursprünglichen, also nicht vergrößerten Zustand zurückversetzt wird, enthält die Oberfläche des Quellwafers Gebiete 18A mit künstlich vergrößerter Oberfläche und Gebiete 18B mit nicht vergrößerter Oberfläche. Das heißt, es entsteht ein Quellwafer mit lokal vergrößerter Oberfläche (Fig. 4A). Eine Schichtabscheidung 46A mit nennenswerter Rate findet nur in den Gebieten statt, wo der Quellwafer 18 eine vergrößerte Oberfläche 18A aufweist. Auf den Stellen des Substrats 18, die einem Gebiet nicht vergrößerter Oberfläche 18B auf dem Quellwafer gegenüberliegen, findet keine oder nur eine stark verlangsamte Schichtabscheidung statt, wie in Fig. 4B gezeigt. Das heißt, es liegt in Fig. 4B ein Substrat 16 mit lokal abgeschiedener Schicht 46A vor.

Die Fig. 4C und 4D zeigen zum Vergleich die Schichtbildung (Schicht 46) auf dem Substrat 16, wenn die Oberfläche des Quellwafers 18 eine homogen vergrößerte Oberfläche aufweist. Es entsteht dann gemäß Fig. 4D ein Substrat 16 mit homogen abgeschiedener Schicht 46. Um zu vermeiden, daß ein erhöhter Bereich 18B des Quellenmaterials bei mehrfacher Verwendung des Quellenmaterials verbleibt, kann das Quellenmaterial ggf. eine vertiefte Stelle oder gar ein Loch an dieser Stelle aufweisen, wie mittels der gestrichelten Linie 56 angedeutet.

In diesem Zusammenhang ist zu erwähnen, daß n-dotierte Si-Wafer sich nur dann elektrochemisch mit einer porösen Schicht versehen lassen, wenn die zu behandelnde Oberfläche mit Licht beschienen wird. Moduliert man dieses Licht z.B. durch Schattenmasken oder Interferenzmuster oder Holographie, läßt sich die Oberfläche nur an den Stellen porosizieren, die von Licht beleuchtet werden. An den dunklen Stellen erfolgt keine Porenbildung. Die so im Quellwafer definierten Strukturen lassen sich bei der Schichtabscheidung auf das Substrat übertragen.

Die obigen Erläuterungen zu den Fig. 4A und 4B befassen sich nur mit der Morphologie bzw. Topographie der abzuscheidenden Schicht. Die Dotierung der abzuscheidenden Schichten ist durch die Dotierung des Wafers mit vergrößerter Oberfläche festgelegt. Eine strukturierte, d.h. lokal unterschiedliche Dotierung des Quellwafers 18 erlaubt somit die Abscheidung von Schichten mit Dotierstrukturen. Dadurch können nachfolgende Prozeßschritte wie z.B. eine Diffusion durch photolithographisch definierte Oxidfenster entfallen.

Durch eine großflächige Anregung, z.B. eine rein thermische Heizung, lassen sich mehrere Substrate gleichzeitig beschichten. Jedes Substrat 16 erfordert seinen eigenen Quellwafer 18 mit vergrößerter Oberfläche. Somit müssen nicht alle abzuscheidenen Schichten notwendigerweise gleich sein. Die freie Wahl des Quellwafers erlaubt die Abscheidung unterschiedlicher Schichten, Schichtdicken und Dotierungen auf verschiedenen Substraten in einem Rezipienten zur gleichen Zeit.

Verwendet man als Quellwafer polykristallines Siliziummaterial, dessen Oberfläche künstlich vergrößert wurde und als Substrat einen einkristallinen Siliziumwafer, läßt sich eine monokristalline Schicht auf dem einkristallinen Substrat aus Material von der polykristallinen Schicht abscheiden.

Die Zugabe dotierstoffhaltiger Gase während des Abscheideprozesses erlaubt eine in situ Dotierung der sich abscheidenden Schichten. Im Falle der Si-Epitaxie können z.B. Diboran für die p-Dotierung und Phosphin für die n-Dotierung eingesetzt werden.

Ein in situ Reinigungsschritt entfernt Oxid von der Oberfläche des Si-Quellwafers und macht die Oberfläche epitaxiefertig. Dazu kann ein Plasma verwendet werden oder der Rezipient bzw. die Quellwaferoberfläche mit TCA oder einem anderen reinigenden bzw. ätzenden Gas gespült werden.

Als Substrat kann auch ein Si-Wafer mit einer hochporösen Schicht und einer darüberliegenden niederporösen Schicht verwendet werden. Als Quelle wird dann ein Si-Wafer mit künstlich vergrößerter, vorzugsweise poröser Oberfläche gewählt. Stellt man einen Temperaturgradienten zwischen Quellwafer und Substrat her, scheidet sich eine monokristalline Si-Schicht auf der niederporösen Si-Oberfläche des Substrats ab. Dabei wird die Temperatur des Substrats so gewählt, daß die hochporöse Schicht im Substrat ihre Porosität behält bzw. vergrößert.

## Patentansprüche

1. Verfahren zum Aufwachsen einer kristallinen Struktur auf einem eine zumindest bereichsweise kristalline Oberfläche (40) aufweisenden Substrat (16) unter Anwendung eines Quellenmaterials (18), das mindestens ein Element enthält, das auf die kristalline Oberfläche zur Bildung der kristallinen Struktur aufgebracht werden soll, bei dem das Quellenmaterial während des Aufwachsverfahrens im festen Zustand vorliegt und eine Flächenausdehnung aufweist, die zumindest im wesentlichen der des Substrats (16) entspricht und zu dieser parallel gegenüberliegend angeordnet ist, bei dem das Quellenmaterial (18) durch seine Porosität und/oder Oberflächenstrukturierung eine größere, wirksame Oberfläche als die des Substrats aufweist und bei dem zumindest das Quellenmaterial auf eine Temperatur unterhalb dessen Schmelzpunkt erhitzt wird.

2. Verfahren nach Anspruch 1, bei dem die einander gegenüberliegenden Oberflächen des Substrats (16) und des Quellenmaterials (18) sich in einer Gasatmosphäre befinden.

3. Verfahren nach Anspruch 2 bei dem, bei Anwendung von Si-Quellenmaterial die Gasatmosphäre aus H₂, Br₂, Cl₂, Ar₂ oder HCl oder aus einer Mischung dieser Gase besteht.

4. Verfahren nach einem der vorhergehenden Ansprüche, bei dem das Substrat (16) und das Quellenmaterial (18) in einem Rezipienten (10) angeordnet werden, der für den Betrieb bei entweder Unterdruck oder Überdruck ausgelegt ist.

5. Verfahren nach Anspruch 4, bei dem der Rezipient bei einem Druck im Bereich von 10⁻⁶ hPa bis 10⁺⁴ hPa betrieben wird.

6. Verfahren nach einem der vorhergehenden Ansprüche, bei dem die Flächenausdehnung der zumindest bereichsweise kristallinen Oberfläche (40) des Substrats (16) und die Flächenausdehnung der diesem gegenüberliegenden Oberfläche des Quellenmaterials (18) zumindest im wesentlichen gleich sind.

7. Verfahren nach einem der vorhergehenden Ansprüche, bei dem der Abstand (A) zwischen der zumindest bereichsweise kristallinen Oberfläche des Substrats (16) und der diesem gegenüberliegenden Oberfläche des Quellenmaterials (18) kleiner als 1/10 der maximalen Flächenausdehnung der Oberfläche des Substrats ist.

8. Verfahren nach einem der vorhergehenden Ansprüche, bei dem der Abstand (A) zwischen der zumindest bereichsweise kristallinen Oberfläche des Substrats und der diesem gegenüberliegenden Oberfläche des Quellenmaterials (18) kleiner als 10 mm ist.

9. Verfahren nach Anspruch 8, bei dem der Abstand (A) kleiner als 1 mm ist.

10. Verfahren nach einem der vorhergehenden Ansprüche, bei dem das Substrat (16) auch beheizt wird.

11. Verfahren nach Anspruch 10, bei dem das Substrat (16) auf eine Temperatur unterhalb der Temperatur des Quellenmaterials beheizt wird.

12. Verfahren nach einem der vorhergehenden Ansprüche, bei dem die zumindest bereichsweise kristalline Oberfläche (40) des Substrats (16) und/oder die der kristallinen Oberfläche gegenüberliegende Oberfläche des Quellenmaterials (18) mit Licht oder einem Plasma angeregt wird.

13. Verfahren nach einem der vorhergehenden Ansprüche, **dadurch gekennzeichnet, daß** man in einem Rezipienten (10) mehrere Substrate (16) und mehrere Materialquellen (18) mit dem gleichen oder unterschiedlichen Materialien benutzt

14. Verfahren nach Anspruch 8, bei dem die relative Zuordnung der einander gegenüberliegenden Substrate (16) und Materialquellen (18) verändert wird.

15. Verfahren nach einem der vorhergehenden Ansprüche, **dadurch gekennzeichnet, daß** die kristalline Oberfläche des Substrats eine dreidimensionale Strukturierung aufweist, und im Ausgangszustand eine äußere Schicht (42) aus Silizium mit einer ersten Porosität und eine innere Schicht (44) aus Silizium mit einer zweiten Porosität aufweist, wobei die zweite Porosität größer ist als die erste Porosität und die innere Schicht (44) sich auf weiterem Substratmaterial befindet.

16. Verfahren nach Anspruch 15 bei dem das weitere Substratmaterial aus Si besteht.

17. Verfahren nach einem der vorhergehenden Ansprüche, bei dem zur Erzeugung von dotierten Schichten Dotierungsstoffe der GasatmoSphäre zwischen dem Substrat und dem Quellenmaterial zugeführt werden.

18. Verfahren nach Anspruch 17, bei dem bei Verwendung von Si als Quellenmaterial Diboran für die p-Dotierung und Phosphin für die n-Dotierung verwendet werden.

19. Verfahren nach einem der vorhergehenden Ansprüche, bei dem ein Quellenmaterial mit Oberflächenbereichen unterschiedlicher Porosität oder Strukturierung oder mit entfernten Bereichen zur Herstellung von lateral strukturierten Kristallschichten verwendet wird.

## Claims

1. Method for growing a crystalline structure on a substrate (16) having an at least regionally crystalline surface (14) using a source material (18) which contains at least one element which is to be applied to the crystalline surface for the formation of the crystalline structure, wherein the source material is present during the growth process in a solid state and has an areal extent which corresponds at least substantially to that of the substrate (16) and is arranged opposite and parallel to the latter, wherein the source material (18) has, through its porosity and/or surface structuring, a larger effective surface than that of the substrate and wherein at least the source material is heated to a temperature below its melting point.

2. Method in accordance with claim 1, in which the oppositely disposed surfaces of the substrate (16) and of the source material (18) are located in a gas atmosphere.

3. Method in accordance with claim 2, wherein, when using Si source material, the gas atmosphere consists of H₂, Br₂, Cl₂, Ar₂ or HCl or of a mixture of these gases.

4. Method in accordance with one of the preceding claims, wherein the substrate (16) and the source material (18) are arranged in a receiver (10) which is designed for operation at sub-atmospheric pressure or above atmospheric pressure.

5. Method in accordance with claim 4, wherein the receiver is operated at a pressure in the range of 10⁻⁶ hPa to 10⁺⁴ hPa.

6. Method in accordance with one of the preceding claims, wherein the area extent of the at least regionally crystalline surface (40) of the substrate (16) and the surface extent of the surface of the source material (18) disposed opposite to it are at least substantially the same.

7. Method in accordance with one of the preceding claims, wherein the spacing (A) between the at least regionally crystalline surface of the substrate (16) and the surface of the source material (18) arranged opposite to it, is smaller than 1/10 of the maximum surface extent of the surface of the substrate.

8. Method in accordance with one of the preceding claims, wherein the spacing (A) between the at least regionally crystalline surface of the substrate and the surface of the source material (18) disposed opposite to it is smaller than 10 mm.

9. Method in accordance with claim 8, wherein the spacing (A) is smaller than 1 mm.

10. Method in accordance with one of the preceding claims, wherein the substrate (16) is also heated.

11. Method in accordance with claim 10, wherein which the substrate (16) is heated to a temperature below the temperature of the source material.

12. Method in accordance with one of the preceding claims, wherein the at least regionally crystalline surface (40) of the substrate (16) and/or the surface of the source material (18) lying opposite to the crystalline surface is excited with light or with a plasma.

13. Method in accordance with one of the preceding claims, **characterised in that** one utilises in one receiver (10) a plurality of substrates (16) and a plurality of material sources (18) with the same or different materials.

14. Method in accordance with claim 8, wherein the relative association of the oppositely disposed substrates (16) and the material sources (18) is changed.

15. Method in accordance with one of the preceding claims, **characterised in that** the crystalline surface of the substrate has a three dimensional structuring and in the starting state has an outer layer (42) of silicon with a first porosity and in an inner layer (44) of silicon with a second porosity, with the second porosity being greater than the first porosity and with the inner layer (44) being located on further substrate material.

16. Method in accordance with claim 15, in which the further substrate material consists of Si.

17. Method in accordance with one of the preceding claims, in which, for the production of doped layers, dopant substances are supplied to the gas atmosphere between the substrate and the source material.

18. Method in accordance with claim 17, in which diborane is used for p-doping and phosphine for the n-doping when using Si as the source material.

19. Method in accordance with one of the preceding claims, in which a source material with surface regions of different porosity or structuring or with removed regions is used for the production of laterally structured crystal layers.

## Revendications

1. Procédé pour la croissance d'une structure cristalline sur un substrat (16) présentant une surface (40) au moins localement cristalline, par application d'un matériau de source (18) qui contient au moins un élément destiné à être appliqué sur la surface cristalline pour former la structure cristalline, dans lequel le matériau de source se présente à l'état solide pendant le procédé de croissance et présente une extension superficielle qui correspond au moins essentiellement à celle du substrat (16) et qui est agencée parallèlement en vis-à-vis de celle-ci, dans lequel le matériau de source (18) présente, de par sa porosité et/ou de par sa structure superficielle, une surface efficace plus grande que celle du substrat, et dans lequel au moins le matériau de source est chauffé à une température au-dessous de son point de fusion.

2. Procédé selon la revendication 1, dans lequel les surfaces opposées l'une à l'autre du substrat (16) et du matériau de source (18) se trouvent dans une atmosphère gazeuse.

3. Procédé selon la revendication 2, dans lequel, lors de l'utilisation de matériau de source en Si, l'atmosphère gazeuse est constituée de H₂, Br₂, Cl₂, Ar₂ ou HCl ou d'un mélange de ces gaz.

4. Procédé selon l'une des revendications précédentes, dans lequel le substrat (16) et le matériau de source (18) sont agencés dans un récipient (10) qui est conçu pour le fonctionnement soit sous dépression soit sous surpression.

5. Procédé selon la revendication 4, dans lequel le récipient est exploité à une pression dans la plage de 10⁻⁶ hPa à 10⁺⁴ hPa.

6. Procédé selon l'une des revendications précédentes, dans lequel l'extension superficielle de la surface (40) au moins localement cristalline du substrat (16) et l'extension superficielle de la surface opposée à celle-ci du matériau de source (18) sont du moins sensiblement égales.

7. Procédé selon l'une des revendications précédentes, dans lequel la distance (A) entre la surface du moins localement cristalline du substrat (16) et la surface opposée à celle-ci du matériau de source (18) est inférieure à un 1/10e de l'extension maximale de la surface du substrat.

8. Procédé selon l'une des revendications précédentes, dans lequel la distance (A) entre la surface du moins localement cristalline du substrat (16) et la surface opposée à celle-ci du matériau de source (18) est inférieure à 10 mm.

9. Procédé selon la revendication 8, dans lequel la distance (A) est inférieure à 1 mm.

10. Procédé selon l'une des revendications précédentes, dans lequel le substrat (16) est également chauffé.

11. Procédé selon la revendication 10, dans lequel le substrat (16) est chauffé à une température au-dessous de la température du matériau de source.

12. Procédé selon l'une des revendications précédentes, dans lequel la surface (40) du moins localement cristalline du substrat (16) et/ou la surface opposée à la surface cristalline du matériau de source (18) est excitée par de la lumière ou par un plasma.

13. Procédé selon l'une des revendications précédentes, **caractérisé en ce que** l'on utilise dans un récipient (10) plusieurs substrats (16) et plusieurs matériaux de source (18) avec le même matériau ou avec des matériaux différents.

14. Procédé selon la revendication 8, dans lequel l'association relative des substrats (16) et des matériaux de source (18) opposés les uns aux autres est modifiée.

15. Procédé selon l'une des revendications précédentes, **caractérisé en ce que** la surface cristalline du substrat présente une structure tridimensionnelle et comprend dans l'état de départ une couche extérieure (42) en silicium avec une première porosité et une couche intérieure (44) en silicium avec une deuxième porosité, la deuxième porosité étant supérieure à la première porosité et la couche intérieure (44) se situant sur un autre matériau de substrat.

16. Procédé selon la revendication 15, dans lequel l'autre matériau de substrat est constitué de Si.

17. Procédé selon l'une des revendications précédentes, dans lequel, pour produire des couches dopées, des substances de dopage sont amenées à l'atmosphère gazeuse entre le substrat et le matériau de source.

18. Procédé selon la revendication 17, dans lequel, lors de l'utilisation de Si à titre de matériau de source, on utilise du diborane pour le dopage p et de la phosphine pour le dopage n.

19. Procédé selon l'une des revendications précédentes, dans lequel on utilise un matériau de source présentant des zones superficielles de porosités ou de structures différentes ou dans lequel des zones de surface ont été supprimées pour produire des couches cristallines structurées latéralement.
